Europäisches Patentamt

European Patent Office

Office européen des brevets

(11) Veröffentlichungsnummer: **0 557 951 A1**

# (12) EUROPÄISCHE PATENTANMELDUNG

(21) Anmeldenummer: **93102847.6**

(22) Anmeldetag: **24.02.93**

(51) Int. Cl.5: **C04B 35/00**, H01L 39/12, H01L 39/24, H01B 12/00

(30) Priorität: **28.02.92 DE 4206160**

(43) Veröffentlichungstag der Anmeldung:
**01.09.93 Patentblatt 93/35**

(84) Benannte Vertragsstaaten:
**AT BE CH DE DK ES FR GB IT LI LU NL SE**

(71) Anmelder: **HOECHST AKTIENGESELLSCHAFT**

**D-65926 Frankfurt(DE)**

(72) Erfinder: **Hettich, Bernhard, Dr.**
**Im Hirtengarten 8**
**W-6239 Eppstein/Ts.(DE)**
Erfinder: **Bestgen, Harro, dr.**
**Hattersheimer Strasse 14**
**W-6233 Kelkheim/Ts.(DE)**
Erfinder: **Elschner, Steffen, Dr.**
**Holbeinstrasse 5d**
**W-6272 Niedernhausen(DE)**
Erfinder: **Weis, Helga**
**Thiotmannstrasse 11**
**W-6230 Frankfurt am Main 80(DE)**
Erfinder: **Lang, Christoph, Dr.**
**Heimchenweg 82**
**W-6230 Frankfurt am Main 80(DE)**

(54) **Oxidkeramisches supraleitendes Material und Verfahren zu seiner Herstellung.**

(57) Die Erfindung betrifft ein Verfahren zur Herstellung eines oxidkeramischen Hochtemperatursupraleiters, der neben Wismut, Strontium und Kupfer zusätzlich eines der Elemente Yttrium, Erbium oder Europium enthält. Die Oxide oder die Oxidvorläufer der Elemente zunächst zerkleinert und gemischt, dann wird das Gemisch mit einer Geschwindigkeit von höchstens 250 K/h auf eine Temperatur von wenigstens 950 °C erhitzt und bei dieser Temperatur über eine Zeitspanne von wenigstens 10 h gehalten. Danach wird das Gemisch innerhalb einer Zeit von höchstens 60 min auf eine Temperatur von 850 °C abgekühlt und gegebenenfalls bei dieser Temperatur über eine Zeitdauer von bis zu 20 h gehalten. Das Mischungsverhältnis der einzelnen Metalle im Reaktionsansatz wird zweckmäßigerweise so eingestellt, daß folgende Atomverhältnisse eingehalten werden:

$Bi_a EA_b Cu_5 O_x$
mit $2.2 \leq a \leq 5$
$6.7 \leq b \leq 8.8$
und EA = Sr + SE
mit $9 \leq Sr/SE \leq 26$
und SE = Y, Eu od. Er.

Die Sprungtemperatur $T_c$ einer Stoffmischung hergestellt nach dem erfindungsgemäßen Verfahren liegt im Bereich von 50 bis 70 K.

EP 0 557 951 A1

Die vorliegende Erfindung betrifft ein Verfahren zur Herstellung eines oxidkeramischen Hochtemperatursupraleiters, der neben Wismut, Strontium und Kupfer zusätzlich eines der Elemente Yttrium, Erbium (Er) oder Europium (Eu) enthält.

Während die konventionellen supraleitenden Materialien ausschließlich bei sehr tiefen Temperaturen eingesetzt werden konnten, die den Einsatz des sehr teuren Kühlmittels Helium erforderten, arbeiten die neuerdings entwickelten supraleitenden oxidischen Substanzen bei wesentlich höheren Temperaturen, die teilweise schon mit dem vergleichsweise billigen Kühlmittel Stickstoff erreichbar sind. Hierdurch verringern sich die Betriebskosten supraleitender Geräte und Anlagen und eröffnen neue, umfassende Anwendungsmöglichkeiten.

Es ist bereits ein oxidischer Supraleiter mit einer Sprungtemperatur von 20 K bekannt, der in oxidischer Form die Elemente Wismut, Strontium und Kupfer im Atomverhältnis 1:1:1 enthält (C. Michel et al., Z. Phys, B 68 (1987) 421). Eine Sprungtemperatur von etwa 20 K ist für technische Zwecke jedoch noch nicht zufriedenstellend.

Oxidische Supraleiter mit höherer Sprungtemperatur, die zusätzlich Calcium enthalten, sind, z.B. aus EP-A 03 27 044, bekannt.

Nach Fuertes et al., Physica C 157 (1989), Seite 421, sind durch zweistufiges Erhitzen einer Mischung von Oxiden von Bi, Sr und Cu bei 950 °C und 700 °C Einkristalle der Verbindung $Bi_4 Sr_8 Cu_5 O_{19+y}$ erhältlich, die jedoch nicht supraleitend sind. Demgegenüber beschreibt die WO 90/02098 supraleitende Metalloxide, die neben Wismut, Strontium und Kupfer auch noch Yttrium enthalten. Die nach der Lehre dieser Schritt herstellbaren Supraleiter sind jedoch bezüglich ihres Mengenanteils an supraleitender Phase in dem Gesamtmaterial noch verbesserungswürdig.

Aufgabe der Erfindung war es, durch Variation der Herstellungsbedingungen zu neuen oxidischen supraleitenden Materialien zu gelangen, die einen größeren Phasenanteil an supraleitender Phase aufweisen.

Gelöst wird diese Aufgabe durch ein Verfahren zur Herstellung einer supraleitenden Stoffmischung, die neben Wismuth, Strontium und Kupfer auch noch eines der Elemente Yttrium, Erbium oder Europium enthält, und dessen kennzeichnende Merkmale darin zu sehen sind, daß die Oxide oder die Oxidvorläufer der Elemente zerkleinert und gemischt werden, daß dann das Gemisch mit einer Geschwindigkeit von höchstens 250 K/h auf eine Temperatur von wenigstens 950 °C erhitzt und bei dieser Temperatur über eine Zeitspanne von wenigstens 10 h gehalten werden, daß das Gemisch dann innerhalb einer Zeit von höchstens 60 min auf eine Temperatur von 850 °C abgekühlt und gegebenenfalls bei dieser Temperatur bis zu 20 h gehalten wird.

Als Oxidvorläufer lassen sich allgemein Verbindungen, die bei der Reaktionstemperatur zu den entsprechenden Oxiden reagieren, einsetzen, insbesondere die Hydroxide und Nitrate. Verwendbar sind ferner die Acetate, Formiate, Oxalate sowie Carbonate der genannten Metalle. Verwendbar sind z.B. Y-$(NO_3)_3$, Strontiumcarbonat, Bismuthsäure, Bismuth-III-oxid und $Cu_2 O$.

Vorzugsweise beträgt im Reaktionsansatz das Mischungsverhältnis der einzelnen Metalle:

$Bi_a EA_b Cu_5 O_x$
mit $2.2 \leq a \leq 5$
$6.7 \leq b \leq 8.8$
und EA = Sr + SE
mit $9 \leq \frac{Sr}{SE} \leq 26$
und SE = Y, Eu od. Er.

Es ist bevorzugt, wenn der erste Tempersschritt bei einer Temperatur von wenigstens 970 °C durchgeführt wird und wenn die Aufheizung mit einer Geschwindigkeit von höchstens 230 K/h durchgeführt wird. Vorzugsweise wird die Temperaturbehandlung in einer oxidierenden Ofenatmosphäre durchgeführt, in der wenigstens 5 Vol.-% Sauerstoff, vorzugsweise wenigstens 10 Vol.-%, aber nicht mehr als 25 Vol.-% Sauerstoff anwesend sind.

Die Zusammensetzung des anfallenden zusammengeschmolzenen Reaktionsprodukts entspricht, bis auf den Sauerstoffgehalt, der Zusammensetzung des Einsatzgemisches.

Die Sprungtemperatur des anfallenden Produkts liegt bei 50 bis 70 K. Durch Messung der magnetischen Suszeptibilität mit einem SQUID-Magnetometer ergeben sich 5 bis 35 Vol.-% an supraleitender Phase.

Die Erfindung wird durch die nachfolgenden Ausführungsbeispiele näher erläutert.

2

Beispiele 1 bis 14:

Die Oxide der Metalle $Bi_2O_3$, SrO, $Y_2O_3$, $Eu_2O_3$, $Er_2O_3$, CuO werden im angegeben Metallverhältnis eingewogen und im Achatmörser gründlich vermischt und zerkleinert. Das homogen aussehende Gemisch wird in ein handelsübliches Schiffchen aus Korund oder MgO oder Gold überführt und der folgenden Temperaturbehandlung unterworfen. Zunächst werden die Proben mit 220 Grad/h auf 980 °C aufgeheizt und dort für $t_1$ h gehalten. Danach wird innerhalb der angegeben Zeit $t_2$ auf 850 °C abgekühlt und bei dieser Temperatur für $t_3$ h gehalten. Anschließend wird der Ofen ausgeschaltet und die Proben im Ofen auf Raumtemperatur abgekühlt. Wichtig ist, daß die Proben bei 980 °C partiell aufschmelzen. Die gesamte Temperaturbehandlung wird unter der angegebenen Atmosphäre durchgeführt. Die so erhaltenen Proben werden in einem SQUID-Magnetometer auf ihre Sprungtemperatur ($T_c$) und ihren supraleitenden Volumenanteil (Meißner- bzw. Shielding-Effekt) hin und in einem Pulverdiffraktometer auf die vorhanden Phasen (Strukturtypen) hin untersucht. Die Ergebnisse dieser Untersuchungen sind ebenfalls angegeben. Das Symbol "485" bedeutet dabei den $Bi_4Sr_8Cu_5O_{19+x}$-Strukturtyp, während das Symbol "2" den $Bi_2EA_3Cu_2O_{8,2}$-Strukturtyp ("Zweischichtverbindung") repräsentiert. Die Symbole "1" und "3" entsprechen der Ein- bzw. Dreischichtverbindung. "X" bedeutet ein Set von Beugungslinien, welche von dem sogenannten 1222- oder 2222-Strukturtyp verursacht werden.

Vergleichsbeispiele A und B:

Mischungen aus $Bi_2O_3$, $SrO_2$, $Y_2O_3$ und CuO wurden zerkleinert gemischt und zu Tabletten gepresst. Die Tabletten wurden dann wie in der WO 90/2098 mit einer Geschwindigkeit von 300 K/h auf eine Temperatur von 900 °C erhitzt und bei dieser Temperatur über eine Zeitdauer von 24 Stunden gehalten. Danach wurden sie im Ofen abkühlen gelassen und anschließend vermessen.

Vergleichsbeispiel C:

Die ausgewiesene Mischung wurde wie in den Beispielen 1 bis 14 behandelt, jedoch wurde statt Luft eine reine Sauerstoffatomsphäre verwendet.

Alle erforderlichen Angaben und Ergebnisse sind in Tabelle 1 zusammengefaßt.

Tabelle 1:

| lfd. Nr. | Zusammensetzung | | | | t1 | t2 | t3 | Atmos-phäre | SL Volumen-anteil % Meißner/ Shielding | Tc | erh. Phasen (XRD) |
|---|---|---|---|---|---|---|---|---|---|---|---|
| | Bi | Sr | Y | Cr | | | | | | | |
| 1 | 4 | 7,4 | 0,6 | 5 | 20 | 60 | 20 | Luft | 10/21 | 60 | 485,2,X |
| 2 | 4 | 7,6 | 0,4 | 5 | 20 | 60 | 20 | Luft | 14/34 | 60 | 485,2,X |
| 3 | 4 | 7,5 | 0,5 | 5 | 20 | 60 | 20 | Luft | 15/30 | 60 | 485,2,X |
| 4 | 5 | 6,75 | 0,75 | 5 | 20 | 60 | 20 | Luft | 11/23 | 50 | 485,2,X |
| 5 | 4 | 7,3 | 0,5 | 5 | 10 | 30 | 10 | Luft | 9/25 | 50 | 485,X |
| 6 | 4,5 | 6,75 | 0,75 | 5 | 10 | 30 | 10 | Luft | 10/30 | 60 | 2,485 |
| 7 | 4,3 | 6,75 | 0,75 | 5 | 10 | 30 | 10 | Luft | 10/35 | 60 | 2,1,485 |
| 8 | 2,2 | 6 | 0,66 | 5 | 10 | 30 | 10 | Luft | 13/18 | 70 | 2,485,3 |
| 9 | 5 | 7,56 | 0,84 | 5 | 10 | 30 | 10 | Luft | 13/25 | 60 | 485,2 |
| 10 | 4 | 7,5 | 0,5 | 5 | 12 | 10 | 0 | Luft | 21/32 | 60 | 482,2 |
| | Bi | Sr | Eu | Cu | | | | | | | |
| 11 | 5 | 7 | 0,5 | 5 | 10 | 30 | 10 | $O_2/N_2$ =1/10 | 13/20 | 60 | 485,X |
| 12 | 4 | 7,7 | 0,3 | 5 | 10 | 30 | 10 | $O_2/N_2$ =1/10 | 14/25 | 70 | 485,2,$Sr_2CuO_3$ |
| 13 | 4 | 7,7 | 0,3 | 5 | 10 | 30 | 10 | Luft | 6/10 | 60 | 485,2,$Sr_2CuO_3$ |
| | Bi | Sr | Er | Cu | | | | | | | |
| 14 | 4 | 7,5 | 0,5 | 5 | 12 | 50 | 3 | Luft | 10/17 | 50 | 485,2 |
| Vergleichsbeispiele: | | | | | | | | | | | |
| | Bi | Sr | Y | Cu | | | | | | | |
| A | 5 | 6,5 | 1 | 5 | nach Vorschrift WO 90/02098 | | | Luft | 3/5 | 70 | 1,2 |
| B | 5 | 6,75 | 0,75 | 5 | | | | Luft | 4/7 | 70 | 1,2 |
| C | 4 | 7,7 | 0,3 | 5 | | | | $O_2$ | -/0,1 | - | 485,2,$Sr_2CuO_3$ |

## Patentansprüche

1. Verfahren zur Herstellung eines oxidkeramischen Hochtemperatursupraleiters, der neben Wismut, Strontium und Kupfer zusätzlich eines der Elemente Yttrium, Erbium oder Europium enthält, dadurch gekennzeichnet, daß die Oxide oder die Oxidvorläufer der Elemente zerkleinert und gemischt werden, daß dann das Gemisch mit einer Geschwindigkeit von höchstens 250 K/h auf eine Temperatur von wenigstens 950 °C erhitzt und bei dieser Temperatur über eine Zeitspanne von wenigstens 10 h gehalten werden, daß das Gemisch dann innerhalb einer Zeit von höchstens 60 min auf eine Temperatur von 850 °C abgekühlt und gegebenenfalls bei dieser Temperatur bis zu 20 h gehalten wird.

2. Verfahren nach Anspruch 1, dadurch gekennzeichnet, daß als Oxidvorläufer Verbindungen eingesetzt werden, die bei der Reaktionstemperatur zu den entsprechenden Oxiden reagieren, vorzugsweise Hydroxide und Nitrate.

3. Verfahren nach Anspruch 1 oder 2, dadurch gekennzeichnet, daß das Mischungsverhältnis der einzelnen Metalle im Reaktionsansatz so eingestellt werden, daß folgende Atomverhältnisse eingehalten werden:

$Bi_a EA_b Cu_5 O_x$
mit $2.2 \leq a \leq 5$
$6.7 \leq b \leq 8.8$
und $EA = Sr + SE$
mit $9 \leq \frac{Sr}{SE} \leq 26$
und $SE = Y$, Eu od. Er.

4. Verfahren nach einem der Ansprüche 1 bis 3, dadurch gekennzeichnet, daß die Mischung mit einer Geschwindigkeit von höchstens 230 K/h auf eine Temperatur von wenigstens 970 °C aufgeheizt wird.

5. Verfahren nach einem der Ansprüche 1 bis 4, dadurch gekennzeichnet, daß die Temperaturbehandlung in einer oxidierenden Ofenatmosphäre durchgeführt, in der wenigstens 5 Vol.-% Sauerstoff, vorzugsweise wenigstens 10 Vol.-%, aber nicht mehr als 25 Vol.-% Sauerstoff anwesend sind.

6. Stoffmischung hergestellt nach einem Verfahren der Ansprüche 1 bis 5, dadurch gekennzeichnet, daß ihre Sprungtemperatur bei 50 bis 70 K liegt.

7. Stoffmischung nach Anspruch 6, dadurch gekennzeichnet, daß der durch die Messung der magnetischen Suszeptibilität mit einem SQUID-Magnetometer bestimmte Volumenanteil an supraleitender Phase 10 bis 35 % beträgt.

| | **EINSCHLÄGIGE DOKUMENTE** | | EP 93102847.6 | |
|---|---|---|---|---|

| Kategorie | Kennzeichnung des Dokuments mit Angabe, soweit erforderlich, der maßgeblichen Teile | Betrifft Anspruch | KLASSIFIKATION DER ANMELDUNG (Int Cl.⁵) |
|---|---|---|---|
| P,X | WO - A - 92/20 107 (HOECHST AKTIENGESELLSCHAFT) * Gesamt * -- | 1-7 | C 04 B 35/00 H 01 L 39/12 H 01 L 39/24 H 01 B 12/00 |
| X | WO - A - 90/02 098 (E.I. DU PONT DE NEMOURS AND COMPANY) * Gesamt * -- | 1,2,4, 6 | |
| A | WO - A - 88/05 029 (UNIVERSITY OF HOUSTON- UNIVERSITY PARK) * Gesamt * -- | 1 | |
| A | EP - A - 0 323 190 (CANON KABUSHIKI KAISHA) * Gesamt * ---- | 1 | |

| | | | RECHERCHIERTE SACHGEBIETE (Int. Cl.⁵) |
|---|---|---|---|
| | | | C 04 B H 01 L H 01 B |

Der vorliegende Recherchenbericht wurde für alle Patentansprüche erstellt.

| Recherchenort WIEN | Abschlußdatum der Recherche 10-05-1993 | Prüfer BECK |
|---|---|---|